Europäisches Patentamt

European Patent Office

Office européen des brevets

(19)

(11) EP 0 618 691 B1

# (12) FASCICULE DE BREVET EUROPEEN

(45) Date de publication et mention
de la délivrance du brevet:
**07.07.1999 Bulletin 1999/27**

(51) Int Cl.6: **H04B 10/08**, H03F 3/08

(21) Numéro de dépôt: **94400672.5**

(22) Date de dépôt: **29.03.1994**

(54) **Dispositif d'évaluation de la qualité de transmission d'un équipement amplificateur optique**

Evaluationsanordnung der Übertragungsqualität einer optischen Verstärkungseinrichtung

Device for evaluation of the transmission quality of an optical amplifier equipment

(84) Etats contractants désignés:
**DE ES GB IT**

(30) Priorité: **30.03.1993 FR 9303674**

(43) Date de publication de la demande:
**05.10.1994 Bulletin 1994/40**

(73) Titulaire: **ALCATEL**
**75008 Paris (FR)**

(72) Inventeurs:
- **Gherardi, Bernard**
  **F-91090 Lisses (FR)**
- **Bourret, Gérard**
  **F-91620 La Ville du Bois (FR)**
- **Leroy, Jean-Bernard**
  **F-28410 Bu (FR)**

(74) Mandataire: **El Manouni, Josiane et al**
**COMPAGNIE FINANCIERE ALCATEL**
**Dépt. Propr. Industrielle,**
**30, avenue Kléber**
**75116 Paris (FR)**

(56) Documents cités:
EP-A- 0 464 445        GB-A- 2 207 827
US-A- 5 013 907

- IEEE MICROWAVE AND GUIDED WAVE
  LETTERS, vol.1, no.9, Septembre 1991, NEW
  YORK US pages 233 - 235 'SCATTERING
  PARAMETER CHARACTERIZATION OF
  MICROWAVE OPTOELECTRONIC DEVICES
  AND FIBER-OPTIC NETWORKS'

## Description

La présente invention a trait d'une manière générale à la fiabilité des liaisons de transmission d'informations, et concerne plus particulièrement un dispositif d'évaluation de la qualité de transmission d'un équipement amplificateur optique utilisé sur une liaison de transmission optique, une telle évaluation étant notamment effectuée en vue de déclencher, en cas de dégradation de la qualité de transmission de cet équipement amplificateur, un mécanisme visant à rétablir la qualité de transmission de cette liaison.

De tels équipements amplificateurs peuvent être constitués par des équipements amplificateurs intermédaires, ou répéteurs, disposés à intervalles réguliers sur une liaison, et permettant d'amplifier les signaux porteurs desdites informations, en vue de compenser l'atténuation qu'ils subissent du fait même de leur transmission sur cette liaison.

Dans le cas de liaisons optiques, et plus particulièrement dans le cas de transmission d'informations numériques sur une liaison optique, il est connu d'utiliser des équipements intermédiaires dits régénérateurs pour traiter les signaux obtenus après conversion optique-électrique des signaux optiques transmis sur cette liaison, ces équipements régénérateurs assurant non seulement une amplification des signaux électriques ainsi obtenus, mais également, compte tenu de la nature numérique de ces informations, une reconstitution aussi fidèle que possible de celles-ci.

Il est en outre connu d'évaluer la qualité de transmission de tels équipements régénérateurs en prévoyant par exemple un élément binaire de parité dans le code utilisé pour la transmission de ces informations et en effectuant, dans ces équipements régénérateurs, une mesure de taux d'erreurs sur lesdits signaux électriques.

Cependant, depuis l'apparition d'amplificateurs dits optiques, tels que par exemple les amplificateurs optiques à fibre dopée ou les amplificateurs optiques à semi-conducteur, aptes à amplifier directement des signaux optiques, il est devenu possible d'utiliser de tels amplificateurs en tant qu'équipements intermédiaires amplificateurs sur une liaison optique. De tels amplificateurs peuvent aussi être utilisés en tant qu'équipements amplificateurs d'extrémité d'une liaison, pour assurer un niveau d'émission et/ou de réception suffisant.

La présente invention a pour objet un dispositif d'évaluation de la qualité de transmission de tels équipements amplificateurs optiques.

La présente invention a ainsi pour objet un dispositif d'évaluation de la qualité de transmission d'un équipement amplificateur optique, essentiellement caractérisé en ce qu'il comporte :

- des moyens pour prélever, en amont dudit équipement amplificateur, par rapport au sens de propagation du signal optique à amplifier par cet équipement amplificateur, une partie de la puissance d'un signal optique se propageant en sens contraire dudit sens de propagation et correspondant à la partie, émise en sens contraire dudit sens de propagation, du bruit créé par ledit équipement amplificateur,

- des moyens pour prélever, en aval dudit équipement amplificateur, par rapport audit sens de propagation, une partie de la puissance optique d'un signal optique se propageant dans ledit sens de propagation et correspondant à la superposition du signal optique amplifié par l'équipement amplificateur, et de la partie, émise dans ledit sens de propagation, du bruit créé par cet équipement amplificateur,

- des moyens pour évaluer le rapport signal-sur-bruit dudit équipement amplificateur, à partir des puissances optiques ainsi prélevées.

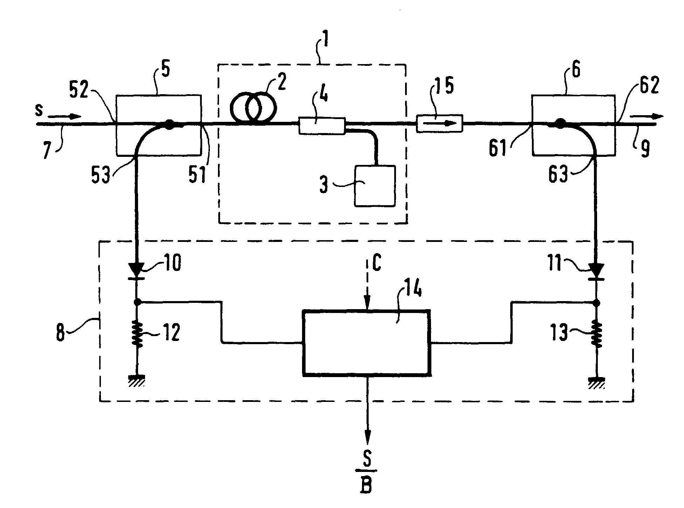

D'autres objets et caractéristiques de la présente invention apparaîtront à la lecture de la description suivante d'un exemple de réalisation, faite en relation avec le dessin ci-annexé représentant un schéma d'un tel exemple de réalisation d'un dispositif suivant l'invention.

Le dispositif d'évaluation de qualité de transmission illustré sur la figure est destiné à évaluer la qualité de transmission d'un équipement amplificateur, noté 1, utilisé par exemple comme équipement répéteur sur une liaison de transmission optique.

Dans l'exemple considéré, cet équipement amplificateur comporte en l'occurence une portion de fibre optique dopée avec des ions de terre rare telle que l'Erbium par exemple, cette portion de fibre dopée étant notée 2, et une source optique dite de pompe, notée 3, fournissant un signal optique dit de pompe permettant à ladite portion de fibre dopée de se comporter en amplificateur optique, et de fixer le gain de cet amplificateur optique. La longueur d'onde du signal optique de pompe est par exemple égale, pour une portion de fibre dopée à l'Erbium, à 1,48 μm ou à 0,98 μm. Ce signal de pompe est multiplexé avec le signal optique incident à amplifier par ledit équipement amplificateur, et porté par une porteuse optique de longueur d'onde égale par exemple à 1,55 μm, dans un multiplexeur en longueur d'onde, noté 4, disposé par exemple à l'extrémité dite aval (par rapport au sens de propagation du signal optique incident à amplifier, repéré par une flèche orientée en l'occurence de la gauche vers la droite) de la portion de fibre dopée.

Outre le fait qu'il amplifie le signal optique incident, noté "s", l'équipement amplificateur 1 constitue cependant une source de bruit, et le rapport signal-sur-bruit en sortie de cet équipement amplificateur est caractéristique de la qualité de transmission de cet équipement amplificateur, une dégradation de ce rapport signal-sur-bruit indiquant une dégradation de cette qualité de transmission.

Dans l'exemple considéré ici d'un équipement amplificateur optique à fibre dopée, le phénomène à l'origine de ce bruit consiste essentiellement dans le phénomène connu sous le nom d'émission spontanée amplifiée, ou ASE ("Amplified Spontaneous Emission").

Pour évaluer ce rapport signal-sur-bruit la présente invention utilise la propriété qu'a ce bruit créé par l'équipement amplificateur d'être émis en partie dans un sens et en partie dans l'autre, à savoir en partie vers l'extrémité dite amont et en partie vers l'extrémité dite aval de la portion de fibre dopée (par rapport au sens de propagation du signal optique incident à amplifier).

Le dispositif suivant l'invention comporte ainsi deux coupleurs optiques, l'un, 5, disposé à l'extrémité dite amont de ladite portion de fibre dopée, et permettant de prélever une fraction de la puissance d'un signal optique se propageant en sens contraire dudit sens de propagation et correspondant à la partie, émise vers ladite extrémité amont, du bruit créé par l'équipement amplificateur, et l'autre, 6, disposé à l'extrémité dite aval de ladite portion de fibre dopée, et destiné à prélever une fraction de la puissance d'un signal optique se propageant dans ledit sens de propagation et correspondant à la superposition du signal optique incident une fois amplifié par l'équipement amplificateur et de la partie, émise vers ladite extrémité aval, du bruit crée par cet équipement amplificateur.

Plus précisément, le coupleur 5 est un coupleur à quatre accès ayant trois accès utilisés ici, dont un, repéré 51, est couplé à l'extrémité amont de ladite portion de fibre dopée, un autre, repéré 52, est couplé à une fibre optique, notée 7, véhiculant le signal optique incident à amplifier, et un autre repéré 53, est couplé à des moyens d'évaluation du rapport signal-sur-bruit, notés 8.

De même le coupleur 6 est un coupleur à quatre accès ayant trois accès utilisés ici,dont un, repéré 61, est couplé à l'extrémité aval de ladite portion de fibre dopée à travers un isolateur 15 assurant le blocage de la transmission dans le sens accès 61 vers portion de fibre dopée, un autre, repéré 62, couplé à une fibre optique, notée 9, véhiculant le signal optique obtenu en sortie de l'équipement amplificateur, et un autre, 63, couplé auxdits moyens d'évaluation du rapport signal-sur bruit.

Les coupleurs 5 et 6 auront avantageusement le même rapport de couplage afin de simplifier ladite évaluation de rapport signal-sur-bruit.

A titre d'exemple lesdits moyens d'évaluation du rapport signal-sur-bruit opèrent sur des signaux électriques obtenus en sortie de moyens de conversion optique-électrique opérant eux-mêmes sur les signaux optiques obtenus sur lesdits accès 53 et 63. Ces moyens de conversion optique-électrique comportent par exemple, associés à chacun desdits coupleurs, un photodétecteur, respectivement 10, 11 couplé à l'accès correspondant de ce coupleur, et délivrant un courant électrique proportionnel à la puissance optique moyenne reçue sur cet accès, et une résistance, respectivement 12, 13 fournissant une tension électrique proportionnelle à ce courant électrique.

Ladite évaluation du rapport signal-sur-bruit, noté $\frac{S}{B}$, pourra être effectuée comme illustré sur le dessin, par des moyens de traitement, 14, opérant en l'occurrence à partir desdites tensions électriques.

Il pourra être nécessaire de tenir compte, dans le traitement effectué par lesdits moyens de traitement 14, de caractéristiques propres à l'équipement amplificateur (et relatives à la fois aux composants qui le constituent et à ses conditions d'utilisation) pour déterminer la relation entre les parties, émises dans ledit sens de propagation et en sens contraire dudit sens de propagation, du bruit créé par l'équipement amplificateur, en vue de déterminer ensuite, suivant des règles qui pourront être classiques et qui ne seront donc pas rappelées ici, ce rapport signal-sur-bruit. Lesdites caractéristiques propres à l'équipement amplificateur sont notées globalement C sur le dessin, et figurées en pointillés pour indiquer cette faculté d'utilisation.

Dans le cas où il importe seulement de détecter une dégradation dans le temps de la qualité de transmission de l'équipement amplificateur, il pourra ne pas être nécessaire de tenir compte de telles caractéristiques dans ladite évaluation du rapport signal-sur-bruit.

Ladite évaluation du rapport signal-sur bruit peut par ailleurs être effectuée soit localement, c'est à dire à l'endroit de l'équipement amplificateur considéré (ce qui correspond au cas illustré sur le dessin), ou être effectuée dans un équipement d'extrémité de ladite liaison, à condition de transmettre les signaux correspondant auxdites tensions électriques (éventuellement sur la même liaison et éventuellement après conversion en numérique) audit équipement d'extrémité.

Dans le cas où ladite évaluation de rapport signal-sur-bruit est effectuée localement, il sera par ailleurs nécessaire, dans le cas où la supervision de la liaison est assurée par un équipement d'extrémité, de transmettre le résultat de cette évaluation à cet équipement d'extrémité.

On notera par ailleurs que dans le cas de plusieurs équipements amplificateurs équipant la même liaison, un isolateur optique tel que celui repéré 15 est avantageusement prévu afin d'éviter une propagation, vers l'équipement amplificateur considéré, du bruit créé par les équipements amplificateurs disposés en aval de cet équipement amplificateur, par rapport au sens de propagation du signal optique à amplifier.

## Revendications

1. Dispositif d'évaluation de la qualité de transmission d'un équipement amplificateur optique (1), caractérisé en ce qu'il comporte :

   - des moyens (5) pour prélever, en amont dudit équipement amplificateur, par rapport au sens de propagation du signal optique à amplifier par cet équipement amplificateur, une partie de la puissance d'un signal optique se propageant en sens contraire dudit sens de propagation et correspondant à la partie, émise en sens contraire dudit sens de propagation, du bruit créé par ledit équipement amplificateur,

- des moyens (6) pour prélever, en aval dudit équipement amplificateur, par rapport audit sens de propagation, une partie de la puissance d'un signal optique se propageant dans ledit sens de propagation et correspondant à la superposition du signal optique amplifié par ledit équipement amplificateur, et de la partie, émise dans ledit sens de propagation, du bruit créé par cet équipement amplificateur,

- des moyens (8) pour évaluer le rapport signal-sur-bruit dudit équipement amplificateur, à partir des puissances optiques ainsi prélevées.

**2.** Dispositif selon la revendication 1, caractérisé en ce que lesdits moyens d'évaluation de rapport signal sur-bruit opèrent en outre à partir de caractéristiques (C) propres audit équipement amplificateur et permettant d'établir une relation entre lesdites parties, émises dans ledit sens de propagation et en sens contraire dudit sens de propagation, du bruit créé par ledit équipement amplificateur.

**3.** Dispositif selon la revendication 1, caractérisé en ce que lesdits moyens d'évaluation du rapport signal-sur-bruit comportent :

- des moyens (10, 11, 12, 13) pour convertir en signaux électriques les signaux optiques issus desdits moyens de prelèvement,

- des moyens (14) d'évaluation de rapport signal-sur-bruit opérant à partir des signaux électriques ainsi obtenus.

**4.** Dispositif selon la revendication 3, caractérisé en ce que lesdits moyens (14) d'évaluation de rapport signal-sur-bruit opèrent en outre à partir desdites caractéristiques (C) propres audit équipement amplificateur.

**Patentansprüche**

**1.** Vorrichtung zur Bewertung der Übertragungsqualität einer optischen Verstärkeranordnung (1), dadurch gekennzeichnet, dass sie umfasst:

- Mittel (5), um in Bezug zur Ausbreitungsrichtung des von dieser Verstärkeranordnung zu verstärkenden optischen Signals vor der Verstärkeranordnung einen Teil der Leistung eines optischen Signals abzugreifen, das sich in Gegenrichtung zu der Ausbreitungsrichtung ausbreitet und dem in Gegenrichtung zur Ausbreitungsrichtung ausgesendeten Teil des von der Verstärkeranordnung erzeugten Rauschens entspricht,

- Mittel (6), um in Bezug zur Ausbreitungsrichtung hinter der Verstärkeranordnung einen Teil der Leistung eines optischen Signals abzugreifen, das sich in der Ausbreitungsrichtung ausbreitet und der Überlagerung des von der Verstärkeranordnung verstärkten optischen Signals und des in der Ausbreitungsrichtung ausgesendeten Teils des von der Verstärkeranordnung erzeugten Rauschens entspricht,

- Mittel (8) zum Bewerten des Signal-Rausch-Verhältnisses der Verstärkeranordnung anhand der so abgegriffenen optischen Leistungen.

**2.** Vorrichtung nach Anspruch 1, dadurch gekennzeichnet, dass die Mittel zum Bewerten des Signal-Rausch-Verhältnisses ferner ausgehend von Eigenschaften (C) arbeiten, die der Verstärkeranordnung zueigen sind und es erlauben, eine Beziehung zwischen den in der Ausbreitungsrichtung und in der Gegenrichtung der Ausbreitungsrichtung ausgesendeten Teilen des von der Verstärkeranordnung erzeugten Rauschens aufzustellen.

**3.** Vorrichtung nach Anspruch 1, dadurch gekennzeichnet, dass die Mittel zum Bewerten des Signal-Rausch-Verhältnisses umfassen:

- Mittel (10, 11, 12, 13) zum Umsetzen der aus den Mitteln zum Abgreifen kommenden Signale in elektrische Signale,

- Mittel (14) zum Bewerten des Signal-Rausch-Verhältnisses, die anhand der so erhaltenen elektrischen Signale arbeiten.

**4.** Vorrichtung nach Anspruch 3, dadurch gekennzeichnet, dass die Mittel (14) zum Bewerten des Signal-Rausch-Verhältnisses ferner anhand der der Verstärkeranordnung zueigenen Eigenschaften (C) arbeiten.

**Claims**

**1.** Device for assessing the transmission quality of an optical amplifier equipment (1), comprising:

- means (5) for sampling on the upstream side of said amplifier equipment relative to the direction of propagation of the optical signal to be amplified by said amplifier equipment part of the power of an optical signal propagating in the direction opposite to said propagation direction and corresponding to that part of the noise generated by said amplifier equipment transmitted in the direction opposite to said propagation direction,

- means (6) for sampling on the downstream side of said amplifier equipment relative to said propagation direction part of the power of an optical signal propagating in said propagation direction and corresponding to the optical signal after amplification by said amplifier equipment superimposed on that part of the noise generated by said amplifier equipment transmitted in said propagation direction, and

- means (8) for assessing the signal-to-noise ratio of said amplifier equipment from the optical powers sampled as above.

2. Device according to claim 1 wherein said means for assessing the signal-to-noise ratio allow for characteristics (C) inherent to said amplifier equipment and enabling a relationship to be established between said parts of the noise generated by said amplifier equipment transmitted in said propagation direction and in the direction opposite to said propagation direction.

3. Device according to claim 1 wherein said means for assessing the signal-to-noise ratio include:

- means (10, 11, 12, 13) for converting into electrical signals the optical signals from said sampling means, and

- means (14) for assessing the signal-to-noise ratio operating on the resulting electrical signals.

4. Device according to claim 3 wherein said means (14) for assessing the signal-to-noise ratio allow for said characteristics (C) inherent to said amplifier equipment.